# EUROPEAN PATENT APPLICATION

(11) **EP 4 834 588 A1**
(43) Date of publication of application: **04.11.2026**
(21) Application number: 24911300.2
(22) Date of filing: 26.12.2024
(51) Int. Cl.: B41F 15/36

(54) **PRINTING SCREEN**

(30) Priority: 29.12.2023 CN 202311873256
(71) Applicant: Shine Optoelectronics (Kunshan) Co., Ltd, Kunshan, Jiangsu 215316 (CN)
(72) Inventor: HONG, Shen, Suzhou, Jiangsu 215316 (CN); GAO, Yulong, Suzhou, Jiangsu 215316 (CN)
(74) Representative: Pfenning, Meinig & Partner mbB
(86) International application number: PCT/CN2024/142634
(87) International publication number: WO 2025/140378

(57) **Abstract**

Disclosed in the present disclosure is a printing screen, comprising a screen body and a surface treatment layer. The screen body comprises a printing side, a bottom side and several penetratingly-arranged grid lines, the printing side and the bottom side being arranged opposite each other. The surface treatment layer is arranged on the printing side and/or the bottom side or in the grid lines, the surface treatment layer comprising micro-nano structures or coating structures. The surface treatment layer is provided on the printing side and/or bottom side of the screen body, so that the resistance of a squeegee on the printing side during printing can be controlled, thereby controlling the amount of ink, improving the uniformity and ink discharge performance; the surface energy of the bottom side can be changed, improving the quality of the printing screen; the scratch resistance of the bottom side can be improved; and the hardness of a lower surface can be changed, improving the performance of the screen body.

## Description

### CROSS REFERENCE TO RELATED APPLICATIONS

The present disclosure claims priority to Chinese patent application filed with the China National Intellectual Property Administration on December 29, 2023, with Application No. 202311873256.9 and entitled "A Printing Screen", the entire contents of which are incorporated herein by reference.

### TECHNICAL FIELD

The present disclosure relates to the technical field of screen printing, and in particular to a printing screen.

### BACKGROUND

A printing screen is an important tool in the electronics field. Taking electrode printing for solar cells as an example, slurry is poured onto the printing screen, and a squeegee drives the slurry to move across the printing screen, so the slurry is extruded through mesh holes of the printing screen onto a solar cell to form a corresponding pattern, thereby fabricating electrodes of the solar cell.

Conventional printing screens are provided with knots formed by intersections of warp and weft threads, which leave knots on the finally fabricated electrodes. Such knots impair the electrical conductivity or conversion efficiency of electrode thin films. To address the above drawbacks, existing printing screens adopt a knot-free design and use a steel mesh. However, the steel mesh has the following defects: the squeegee cannot be easily controlled, the slurry cannot be discharged evenly, the performance is not stable enough, resulting in a short service life. Accordingly, there is an urgent need to provide a printing screen with a novel structure to solve the technical problems existing in the prior art.

### SUMMARY

Accordingly, it is necessary to provide a printing screen to solve the above technical problems.

One technical solution of the present disclosure is as follows:
The present disclosure provides a printing screen, including: a screen body including a printing surface, a bottom surface and a plurality of through-penetrating grid lines, wherein the printing surface and the bottom surface are arranged opposite to each other; and a surface treatment layer provided on the printing surface and/or the bottom surface or inside the grid lines, wherein the surface treatment layer includes a microstructure or a coating structure.

In some embodiments, the surface treatment layer includes a microstructure provided on the printing surface, and the microstructure includes a mesh texture, an AG texture, a brushed texture or a composite texture.

In some embodiments, the microstructure protrudes from and/or is recessed from the printing surface.

In some embodiments, the screen body includes a first metal layer and a second metal layer that are stacked; the printing surface is provided on the first metal layer, and the bottom surface is provided on the second metal layer; the microstructure is recessed from the printing surface, and a recess depth is less than or equal to a thickness of the first metal layer.

In some embodiments, the mesh texture has a thickness or depth ranging from 3 µm to 25 µm, inclusive, an average pore size of grids ranging from 10 µm to 200 µm, inclusive, and a mesh line width ranging from 5 µm to 150 µm, inclusive; the AG texture has a thickness or depth not exceeding 25 µm, and a width ranging from 5 µm to 150 µm; the brushed texture has a thickness or depth ranging from 3 µm to 25 µm, inclusive, and a width ranging from 5 µm to 150 µm, inclusive.

In some embodiments, the composite texture includes a mesh texture and an AG structure provided on the mesh texture; the AG structure has a height ranging from 10 nm to 5 µm, and a width ranging from 50 nm to 50 µm.

In some embodiments, the grid lines of the screen body are defined to extend along a Y direction, and an X direction crossing the Y direction is defined as a printing direction; along the X direction, the microstructure is provided with an adjustment portion for adjusting resistance of a squeegee during printing.

In some embodiments, in a Z direction perpendicular to a plane formed by the X direction and the Y direction, the adjustment portion has a depth ranging from 3 µm to 25 µm when recessed, and a thickness ranging from 3 µm to 25 µm when protruding.

In some embodiments, the adjustment portion is a tip portion directed opposite to the X direction.

In some embodiments, the adjustment portion is linear and arranged at an included angle relative to the X direction.

In some embodiments, the microstructure is a mesh texture including intersecting first mesh lines and second mesh lines, wherein the first mesh lines and/or the second mesh lines are arranged at an included angle relative to the X direction.

In some embodiments, the included angle ranges from 5° to 85°.

In some embodiments, the surface treatment layer includes a microstructure provided on the bottom surface, and the microstructure includes an AG texture.

In some embodiments, the surface treatment layer includes a coating structure provided on the bottom surface, and the coating structure is a fluorine-containing layer, a softening layer or a plating layer.

In some embodiments, the screen body includes a first metal layer and a second metal layer that are stacked; the grid lines of the screen body include first wire grooves located in the first metal layer and second wire grooves located in the second metal layer, wherein the first wire grooves and the second wire grooves overlap and communicate with each other; the printing surface is provided on the first metal layer, and the bottom surface is provided on the second metal layer; side walls of the first wire grooves and/or the second wire grooves are provided with fluorine-containing layers or plating layers.

The beneficial effects of the present disclosure are: the printing screen of the present disclosure is provided with a surface treatment layer on the printing surface and/or the bottom surface of the screen body. The surface treatment layer can control squeegee resistance on the printing surface during printing, control slurry amount, and improve slurry uniformity and slurry discharge performance. The surface treatment layer can adjust the surface energy of the bottom surface to improve the quality of the printing screen, enhance scratch resistance of the bottom surface, and change the hardness of the bottom surface to optimize overall performance of the screen body. By providing the surface treatment layer on the screen body, a high-performance printing screen is obtained with improved quality, prolonged service life and improved printing effect.

### BRIEF DESCRIPTION OF THE DRAWINGS

FIG. 1 is a schematic plan structural view of a printing screen of the present disclosure.
FIG. 2 is a schematic cross-sectional structural view of the printing screen shown in FIG. 1.
FIG. 3 is another schematic cross-sectional structural view of a printing screen of the present disclosure.
FIG. 4 is another schematic cross-sectional structural view of a printing screen of the present disclosure.
FIG. 5 is another schematic plan structural view of a printing screen of the present disclosure.
FIG. 6 is another schematic cross-sectional structural view of a printing screen of the present disclosure.
FIG. 7 is another schematic cross-sectional structural view of a printing screen of the present disclosure.
FIG. 8 is another schematic cross-sectional structural view of a printing screen of the present disclosure.
FIG. 9 is another schematic cross-sectional structural view of a printing screen of the present disclosure.
FIG. 10 is another schematic cross-sectional structural view of a printing screen of the present disclosure.
FIG. 11 is another schematic cross-sectional structural view of a printing screen of the present disclosure.
FIG. 12 is another schematic cross-sectional structural view of a printing screen of the present disclosure.
FIG. 13 is another schematic cross-sectional structural view of a printing screen of the present disclosure.
FIG. 14 is another schematic cross-sectional structural view of a printing screen of the present disclosure.
FIG. 15 is another schematic cross-sectional structural view of a printing screen of the present disclosure.
FIG. 16 is another schematic cross-sectional structural view of a printing screen of the present disclosure.
FIG. 17 is another schematic cross-sectional structural view of a printing screen of the present disclosure.
FIG. 18 is another schematic cross-sectional structural view of a printing screen of the present disclosure.

### DETAILED DESCRIPTION

For a better understanding of the present disclosure, it will be described below more comprehensively with reference to the accompanying drawings. Preferred embodiments of the present disclosure are shown in the accompanying drawings. However, the present disclosure may be implemented in many different forms and shall not be limited to the embodiments described hereinafter. On the contrary, these embodiments are provided to render the present disclosure more thorough and complete.

It should be noted that when an element is referred to as being "arranged on" another element, it may be directly on the other element, or intermediate elements may also be present therebetween. When an element is referred to as being "connected to" another element, it may be directly connected to the other element, or intermediate elements may also exist. The terms "vertical", "horizontal", "left", "right" and similar expressions used herein are for illustrative purposes only and do not represent the only embodiments.

Unless otherwise defined, all technical and scientific terms used herein have the same meanings as commonly understood by those skilled in the technical field to which the present disclosure pertains. The terms used in the specification of the present disclosure herein are only for the purpose of describing specific embodiments and are not intended to limit the present disclosure. The term "and/or" used herein includes any and all combinations of one or more of the associated listed items.

The present disclosure provides a printing screen including a screen body and a surface treatment layer. The screen body includes a printing surface, a bottom surface and a plurality of through-penetrating grid lines, and the printing surface and the bottom surface are arranged opposite to each other. The surface treatment layer is provided on the printing surface and/or the bottom surface and/or inside the grid lines, and the surface treatment layer includes a microstructure and/or a coating structure. The surface treatment layer provided on the printing surface and/or the bottom surface of the screen body can control squeegee resistance on the printing surface during printing, control slurry amount, and improve uniformity and slurry discharge performance. The surface treatment layer can adjust the surface energy of the bottom surface to enhance the quality of the printing screen, increase the scratch resistance of the bottom surface, and change the hardness of the bottom surface to improve the overall performance of the screen body. By providing the surface treatment layer on the screen body, a high-performance printing screen is obtained with improved quality, prolonged service life and improved printing effect.

In one embodiment, the surface treatment layer includes a microstructure provided on the printing surface, and the microstructure includes a mesh texture, an AG texture, a brushed texture or a composite texture. The microstructure provided on the printing surface can control squeegee resistance during printing so as to adjust slurry amount and improve printing quality. The microstructure protrudes from and/or is recessed from the printing surface. The surface treatment layer may be not integrally formed on the printing surface; for example, the microstructure may be formed on the printing surface through film coating, coating or other processes. The surface treatment layer may also be integrally formed with the printing surface: the microstructure may integrally protrude from the printing surface, or may be recessed from the printing surface. The mesh texture refers to a texture distributed in a grid pattern, with mesh lines arranged in protruding and/or recessed forms. The AG texture includes a plurality of protruding structures and/or recessed structures, wherein at least one parameter of the protruding or recessed structures such as height, depth, width, length, density, period, curvature and cross-section is randomly set. For instance, an AG texture may be formed by randomly setting the height, period and curvature of multiple protruding structures. The brushed texture refers to a texture with a brushed appearance. The composite texture is a superposition of two types of textures, such as providing AG structures on a mesh texture, providing AG structures on a brushed texture, providing an AG structures on another AG texture, providing a brushed texture on a mesh texture, and the like. The AG structures include a plurality of protruding structures and/or recessed structures, wherein at least one parameter of the protruding or recessed structures such as height, depth, width, length, density, period, curvature and cross-section is randomly set. The AG texture has a thickness or a depth not exceeding 25 µm, and a width of the AG texture ranges from 5 µm to 150 µm. The AG structure has a height ranging from 10 nm to 5 µm and a width ranging from 50 nm to 50 µm.

In one embodiment, the screen body includes a first metal layer and a second metal layer that are stacked; the printing surface is provided on the first metal layer, and the bottom surface is provided on the second metal layer. The microstructure is recessed from the printing surface, and a recess depth is less than or equal to a thickness of the first metal layer. The microstructure is in a groove shape, and may or may not penetrate the first metal layer. By providing the microstructure in the groove shape and formed on the first metal layer, the printing surface of the first metal layer has excellent printing performance, which can effectively control squeegee resistance during printing to control slurry amount and improve printing quality.

In one embodiment, to effectively control squeegee resistance, the mesh texture has a thickness or depth ranging from 3 µm to 25 µm, inclusive, an average pore size of grids ranging from 10 µm to 200 µm, inclusive, and a mesh line width ranging from 5 µm to 150 µm, inclusive. The AG texture has a thickness or depth not exceeding 25 µm, and a width ranging from 5 µm to 150 µm. The brushed texture has a thickness or depth ranging from 3 µm to 25 µm, inclusive, and a width ranging from 5 µm to 150 µm, inclusive.

In one embodiment, the composite texture includes a mesh texture and AG structures provided on the mesh texture. The mesh texture has a thickness or depth ranging from 3 µm to 25 µm, inclusive, an average pore size of grids ranging from 10 µm to 200 µm, and a mesh line width ranging from 5 µm to 150 µm, inclusive. The AG structure has a height ranging from 10 nm to 5 µm, inclusive and a width ranging from 50 nm to 50 µm, inclusive, which can effectively control squeegee resistance during printing to control slurry amount and improve printing quality.

In one embodiment, the grid lines of the screen body are defined to extend along a Y direction, and an X direction crossing the Y direction is defined as a printing direction. Along the X direction, the microstructure is provided with an adjustment portion for adjusting squeegee resistance during printing. In a Z direction perpendicular to a plane formed by the X direction and the Y direction, the adjustment portion has a thickness or a depth ranging from 3 µm to 25 µm, inclusive. The adjustment portion is arranged along the X direction during squeegee printing and has a certain thickness in the Z direction, which can provide a resisting effect on the squeegee, thereby adjusting the squeegee force and ensuring the strength, smoothness and uniformity of slurry scraping.

In one embodiment, the adjustment portion is a tip portion directed opposite to the X direction. The tip portion can provide resistance to the squeegee without restricting its movement, so as to facilitate the adjustment function.

In one embodiment, the adjustment portion is linear and arranged at an included angle relative to the X direction. The linear adjustment portion may be linear mesh lines of the texture, linear AG textures or linear brushed textures. The linear adjustment portion forms an included angle with an slurry squeegee direction of the squeegee, and preset adjustment effects can be achieved by setting different included angles.

In one embodiment, the microstructure is a mesh texture including intersecting first mesh lines and second mesh lines, and the first mesh lines and/or the second mesh lines are arranged at an included angle relative to the X direction. Preferably, the included angle ranges from 15° to 75°. In one embodiment, the X-axis is perpendicular to the Y-axis. Within a coordinate system formed by the X-axis and Y-axis, the overall mesh texture is obliquely arranged; the first mesh lines and the second mesh lines are each inclined relative to the X-axis. An intersection of one first mesh line and one second mesh line forms an adjustment portion directed opposite to the X-axis, and the first mesh line and second mesh line forming the intersection also serve as adjustment portions with favorable adjustment performance.

In one embodiment, the surface treatment layer includes a microstructure provided on the bottom surface, and the microstructure includes an AG texture. By providing the AG texture on the bottom surface, the bottom surface forms a textured surface to provide scratch resistance, so that a high-quality printing screen is obtained.

In one embodiment, the surface treatment layer includes a coating structure provided on the bottom surface, and the coating structure is a fluorine-containing layer, a softening layer or a plating layer, thereby improving the surface energy of the bottom surface to obtain a high-quality printing screen.

In one embodiment, the screen body includes a first metal layer and a second metal layer that are stacked. The grid lines of the screen body include first wire grooves located in the first metal layer and second wire grooves located in the second metal layer, and the first wire grooves and the second wire grooves overlap with each other. The printing surface is provided on the first metal layer, and the bottom surface is provided on the second metal layer. Side walls of the first wire grooves and/or the second wire grooves are provided with fluorine-containing layers or plating layers, thereby improving the surface energy of the first wire grooves or the second wire grooves, stabilizing the structure and obtaining a high-quality printing screen.

The printing screen of the present disclosure will be described below with reference to the accompanying drawings by way of example.

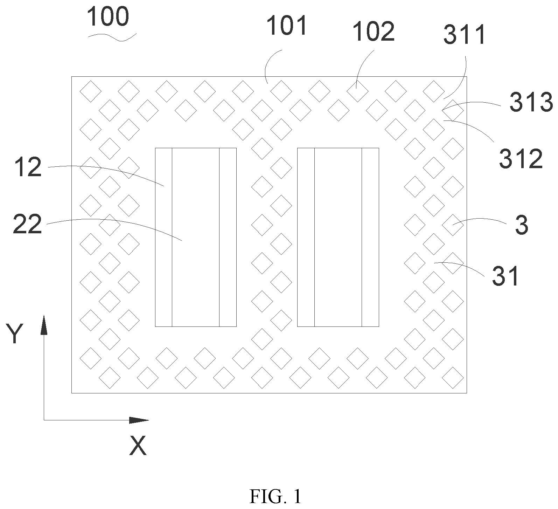

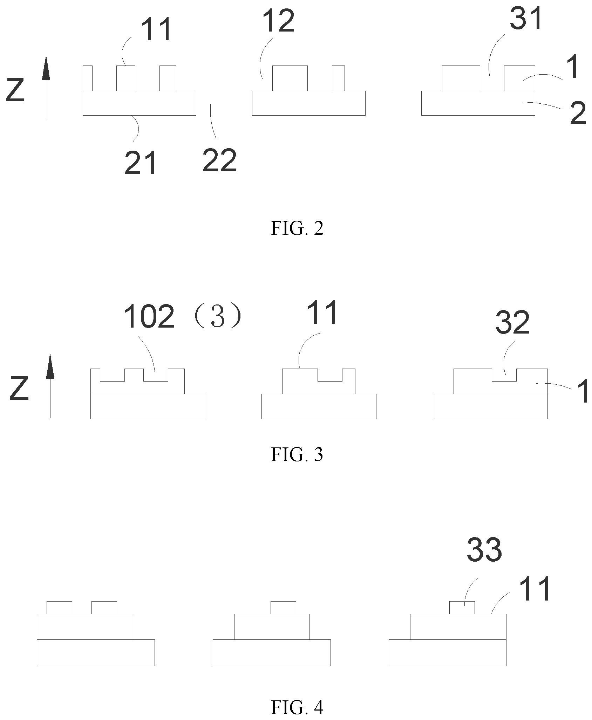

With reference to FIG. 1 and FIG. 2, the present disclosure provides a printing screen 100 including a screen body 101 and a surface treatment layer 102. The screen body 101 includes a first metal layer 1, a second metal layer 2 and a plurality of grid lines. The first metal layer 1 and the second metal layer 2 are stacked. The screen body 101 has a printing surface 11 located on the first metal layer 1 and a bottom surface 21 located on the second metal layer 2, and the printing surface 11 and the bottom surface 21 are arranged opposite to each other. The grid lines of the screen body include first wire grooves 12 penetrating through the first metal layer 1 and second wire grooves 22 penetrating through the second metal layer 2; the first wire grooves 12 and the second wire grooves 22 overlap and communicate with each other. The surface treatment layer 102 includes a microstructure 3 provided on the printing surface 11. In this embodiment, the microstructure 3 includes a mesh texture 31 recessed from the printing surface 11. The mesh texture 31 can control squeegee resistance (the squeegee is not shown) on the printing surface 11 during printing, so as to control slurry amount, improve slurry uniformity and slurry discharge performance.

Still referring to FIG. 1 and FIG. 2, the grid lines of the screen body are defined to extend along the Y direction, and the printing direction is defined as the X direction. In this embodiment, the X direction is perpendicular to the Y direction, and the Z direction is defined as the direction perpendicular to the plane formed by the X direction and the Y direction. The mesh texture 31 includes intersecting first mesh lines 311 and second mesh lines 312. The overall mesh texture 31 is obliquely arranged within the X-Y coordinate system, and the first mesh lines 311 and the second mesh lines 312 each form an included angle relative to the X direction. Preferably, the included angle ranges from 5° to 85°. An intersection of a first mesh line 311 and a second mesh line 312 directed opposite to the X direction is defined as an adjustment portion 313; the first mesh line 311 and the second mesh line 312 forming the intersection also serve as adjustment portions. The adjustment portion 313 is a tip portion directed opposite to the X direction, and the first mesh line 311 and the second mesh line 312 forming the intersection are linear adjustment portions arranged at an included angle relative to the X direction. The adjustment portions arranged along the X direction can provide effective resistance to the squeegee to adjust the squeegee during printing, thereby ensuring slurry scraping quality. To effectively control squeegee resistance, a depth of the mesh texture 31 is less than or equal to a thickness of the first metal layer 1, with a preferred range of 3 µm to 25 µm, inclusive. Further, a width of each first mesh line 311 ranges from 5 µm to 150 µm, a width of each second mesh line 312 ranges from 5 µm to 150 µm, and an average pore size of grids of the mesh texture 31 ranges from 10 µm to 200 µm. This configuration avoids obstruction to the squeegee while achieving effective control over squeegee resistance. The included angles of multiple first mesh lines 311 are the same or substantially the same with a difference not exceeding 5%; the included angles of multiple second mesh lines 312 are the same or substantially the same with a difference not exceeding 5%, so as to ensure stable adjustment effects.

As shown in FIG. 2, the depth of the mesh texture 31 in the Z direction is equal to the thickness of the first metal layer 1, that is, the mesh texture 31 is recessed from the printing surface 11 to penetrate the first metal layer 1. In other embodiments, as shown in FIG. 3, the depth of a mesh texture 32 in the Z direction is smaller than the thickness of the first metal layer 1, that is, the mesh texture 32 is recessed from the printing surface 11 without penetrating the first metal layer 1. The surface treatment layer 102 formed by the microstructure 3 with the mesh texture 32 having a depth no less than 3 µm is arranged on the printing surface 11 to control squeegee resistance and improve printing quality. The microstructure 3 is formed by recessing from the printing surface 11. In other embodiments, the microstructure 3 may also protrude from the printing surface 11. As shown in FIG. 4, a mesh texture 33 protrudes from the printing surface 11, and may be formed on the printing surface 11 through printing, laser etching, spraying, coating embossing or other processes. The protruding mesh texture 33 has a height ranging from 3 µm to 25 µm, inclusive, which can act on the squeegee without blocking the squeegee's movement, adjust squeegee resistance and improve printing quality. In other embodiments, the mesh texture may be partially protruding and partially recessed.

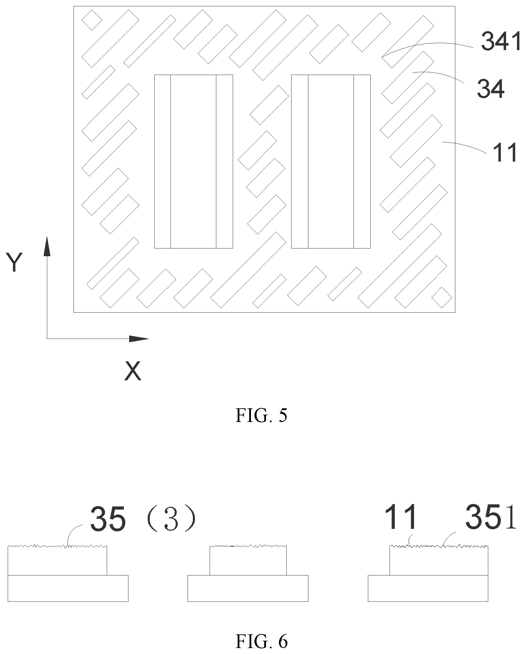

As shown in FIG. 2, the microstructure 3 is the mesh texture 31. In other embodiments, the microstructure 3 is a brushed texture 34 as shown in FIG. 5. The brushed texture 34 is obliquely arranged relative to the X-axis, and an included angle relative to the X-axis ranges from 5° to 85°. A width of the brushed texture 34 ranges from 5 µm to 150 µm. The brushed texture 34 may protrude or be recessed from the printing surface 11, having a thickness ranging from 3 µm to 25 µm, inclusive when protruding and a depth ranging from 3 µm to 25 µm, inclusive when recessed. One end of the brushed texture 34 forms an adjustment portion 341 with favorable adjustment performance. The brushed texture 34 may have variable width, variable length and variable spacing, and the entire brushed texture inclines toward the same direction. In other embodiments, the difference of inclination angles does not exceed 5%. The brushed texture 34 may be arranged to protrude and/or be recessed from the printing surface 11. As shown in FIG. 6, the microstructure 3 is an AG texture 35. In this embodiment, the AG texture 35 is provided on the surface of the printing surface 11; the height, width and spacing of the AG texture 35 are randomly arranged on the printing surface 11, and the AG texture 35 is arranged to protrude and/or be recessed from the printing surface 11. One end of the AG texture 35 directed opposite to the X direction is provided with an adjustment portion 351. The AG texture has a height not exceeding 25 µm and a depth not exceeding 25 µm. The AG texture provided on the printing surface 11 can control squeegee resistance and improve printing quality.

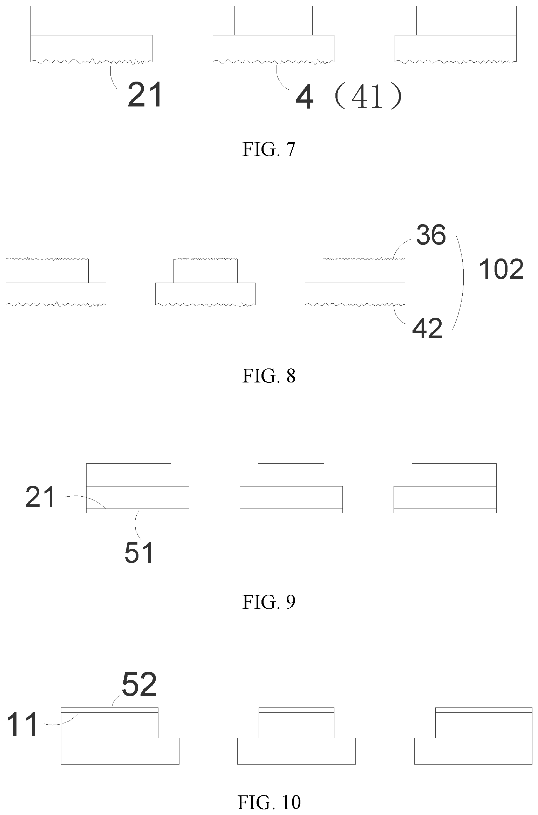

As shown in FIG. 7, the surface treatment layer 102 is a microstructure 4 provided on the bottom surface 21, and the microstructure 4 includes an AG texture 41. The AG texture 41 is arranged to protrude and/or be recessed from the bottom surface 21, with a height not exceeding 25 µm and a depth not exceeding 25 µm, so as to form a textured surface on the bottom surface 21 for scratch resistance and improved quality.

As shown in FIG. 8, the surface treatment layer 102 is a microstructure including an AG texture 36 provided on the printing surface and an AG texture 42 provided on the bottom surface. The AG texture 36 can control squeegee resistance, and the AG texture 42 provides scratch resistance to enhance overall quality. The AG texture 36 has a thickness or a depth not exceeding 25 µm, and a width ranging from 5 µm to 150 µm. In other embodiments, the AG texture 36 is formed of AG structures with a height ranging from 10 nm to 5 µm and a width ranging from 50 nm to 50 µm.

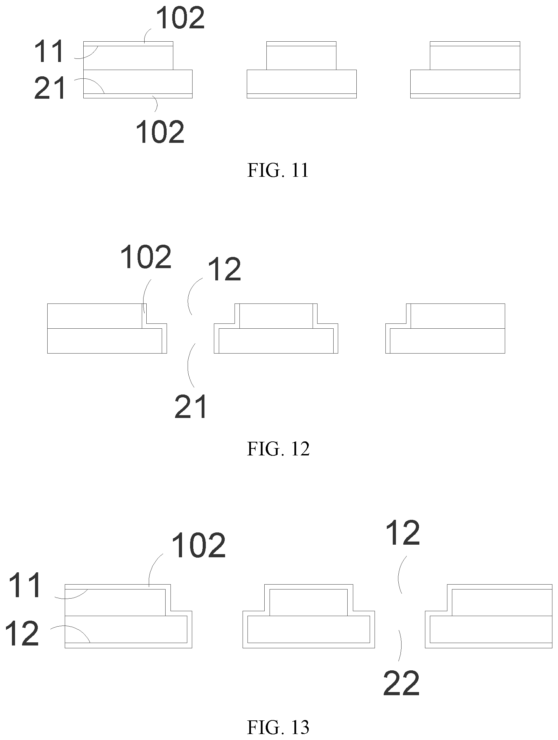

As shown in FIG. 9, the surface treatment layer 102 is a coating structure 51 provided on the bottom surface 21. The coating structure 51 is a fluorine-containing layer or a softening layer with a thickness ranging from 5 µm to 100 µm, thereby improving the surface energy of the bottom surface and thus enhancing product quality. In other embodiments, the surface treatment layer 102 is a plating layer 51 arranged on the bottom surface 21 with a thickness ranging from 20 nm to 5 µm to improve the bottom surface and product quality. As shown in FIG. 10, the surface treatment layer 102 is a coating structure 52 or a plating layer 52 provided on the printing surface 11. In other embodiments, as shown in FIG. 11, the surface treatment layer 102 is provided on both the printing surface 11 and the bottom surface 21, and may be a fluorine-containing layer, a softening layer or a plating layer. As shown in FIG. 12, the surface treatment layer 102 is arranged inside the grid lines, i.e., on the side walls of the first wire grooves 12 and the side walls of the second wire grooves 22, so as to improve surface energy and enhance the quality of wire grooves. As shown in FIG. 13, the surface treatment layer 102 is provided on the printing surface 11, the first wire grooves 12, the bottom surface 21 and the second wire grooves 22 to comprehensively improve the surfaces and improve the quality of the printing screen.

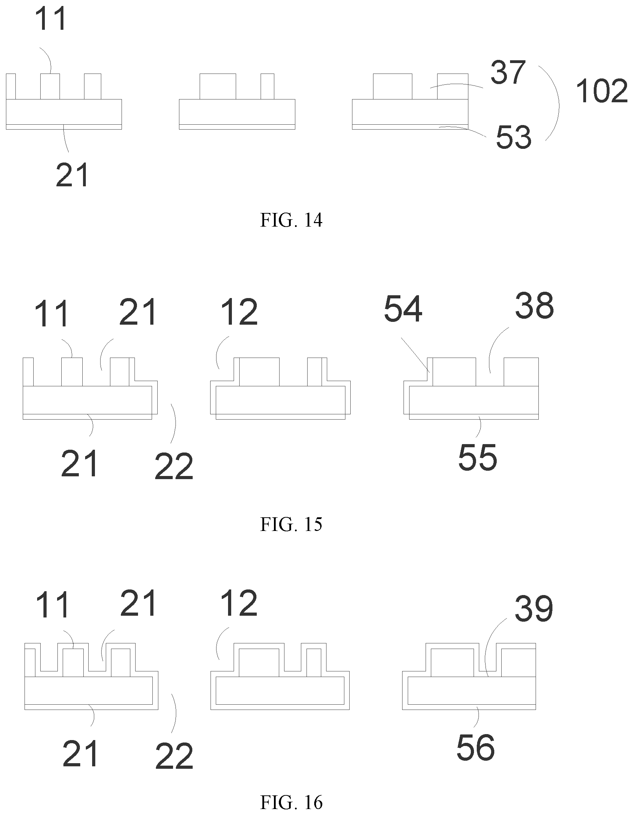

As shown in FIG. 14, the surface treatment layer 102 includes a mesh texture 37 provided on the printing surface 11 and a plating layer 53 arranged on the bottom surface 21. The mesh texture 37 controls squeegee resistance, and the plating layer 53 improves surface energy, thereby obtaining a high-quality printing screen and improving printing quality. As shown in FIG. 15, the surface treatment layer includes a mesh texture 38 provided on the printing surface 11, plating layers 54 provided on the side walls of the first wire grooves 12 and the second wire grooves 22, and a fluorine-containing layer 55 provided on the bottom surface 21. As shown in FIG. 16, the surface treatment layer includes a mesh texture 39 provided on the printing surface 11 and plating layers 56 provided on the mesh texture 39, the printing surface 11, the first wire grooves 12, the second wire grooves 22 and the bottom surface, and so on. The surface treatment layer is arranged on at least one of the printing surface 11, the side walls of the first wire grooves 12, the side walls of the second wire grooves 22 and the bottom surface, to realize surface treatment functions including controlling squeegee resistance, improving surface energy, providing scratch resistance and achieving surface softening, so as to improve printing quality, prolong product service life, enhance product quality and reduce costs.

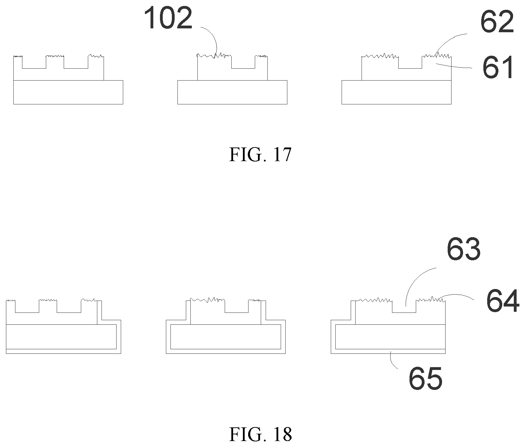

As shown in FIG. 17, the surface treatment layer 102 includes a composite texture provided on the printing surface. The composite texture includes a mesh texture 61 and AG structures 62 provided on the mesh texture 61. The mesh texture 61 has a depth ranging from 3 µm to 25 µm, inclusive; an average pore size of grids ranging from 10 µm to 200 µm, and a mesh line width ranging from 5 µm to 150 µm, inclusive. The AG structure has a height ranging from 10 nm to 5 µm and a width ranging from 50 nm to 50 µm, inclusive. The mesh lines of the mesh texture 61 intersect perpendicularly or non-perpendicularly and form an included angle of 0° to 90° relative to the X direction; the width of the mesh lines may be substantially uniform or non-uniform. The AG structures 62 are arranged on the surface of the mesh texture 61. In other embodiments, the AG structures may be provided on the surface of the mesh texture 61, the side walls of mesh lines and inside mesh holes. The AG structures may be uniformly distributed, regionally distributed or locally distributed. The composite texture can realize surface treatment functions including controlling squeegee resistance, improving surface energy, providing scratch resistance and achieving surface softening, thereby improving printing quality, prolonging product service life, enhancing strength, toughness and overall quality, and reducing production costs.

As shown in FIG. 18, the surface treatment layer includes a composite texture. The composite texture includes a mesh texture 63 provided on the printing surface and AG structures 64 provided on the mesh texture 63. The surface treatment layer further includes plating layers 65 provided on the side walls of the first wire grooves, the side walls of the second wire grooves and the bottom surface. This configuration achieves surface treatment functions including controlling squeegee resistance, improving surface energy, providing scratch resistance and achieving surface softening, so as to improve printing quality, prolong product service life, enhance strength, toughness and overall quality, and reduce costs.

To make the above objects, features and advantages of the present disclosure more apparent and understandable, the specific embodiments of the present disclosure have been described in detail above with reference to the accompanying drawings. Numerous specific details are set forth in the foregoing description to facilitate full understanding of the present disclosure. However, the present disclosure may be implemented in many other manners different from those described above, and those skilled in the art may carry out similar modifications without departing from the connotation of the present disclosure. Therefore, the present disclosure should not be limited to the specific embodiments disclosed above. In addition, each technical feature of the above embodiments may be combined arbitrarily. For the sake of concise description, not all possible combinations of each technical feature in the above embodiments are elaborated herein. Nevertheless, any combination of such technical features without contradictions should be deemed to fall within the scope described in this specification.

The above embodiments only illustrate several embodiments of the present disclosure. Although their descriptions are relatively specific and detailed, they should not be construed as limiting the patent scope of the present disclosure. It should be noted that for those of ordinary skill in the art, various variations and improvements may be made without departing from the conception of the present disclosure, all of which should fall within the protection scope of the present disclosure. Therefore, the protection scope of the patent of the present disclosure should be defined by the appended claims.

## Claims

1. A printing screen comprising:
a screen body comprising a printing surface, a bottom surface and a plurality of through-penetrating grid lines, wherein the printing surface and the bottom surface are arranged opposite to each other; and
a surface treatment layer provided on the printing surface and/or the bottom surface or inside the grid lines, wherein the surface treatment layer comprises a microstructure or a coating structure.

2. The printing screen of claim 1, wherein the surface treatment layer comprises a microstructure provided on the printing surface, and the microstructure comprises a mesh texture, an AG texture, a brushed texture or a composite texture.

3. The printing screen of claim 2, wherein the microstructure protrudes from and/or is recessed from the printing surface.

4. The printing screen of claim 2, wherein the screen body comprises a first metal layer and a second metal layer that are stacked; the printing surface is provided on the first metal layer, and the bottom surface is provided on the second metal layer; the microstructure is recessed from the printing surface, and a recess depth is less than or equal to a thickness of the first metal layer.

5. The printing screen of claim 2, wherein the mesh texture has a thickness or depth ranging from 3 µm to 25 µm, inclusive, an average pore size of grids ranging from 10 µm to 200 µm, inclusive, and a mesh line width ranging from 5 µm to 150 µm, inclusive;
the AG texture has a thickness or depth not exceeding 25 µm, and a width ranging from 5 µm to 150 µm;
the brushed texture has a thickness or depth ranging from 3 µm to 25 µm, inclusive, and a width ranging from 5 µm to 150 µm, inclusive.

6. The printing screen of claim 2, wherein the composite texture comprises a mesh texture and AG structures provided on the mesh texture; each AG structure has a height ranging from 10 nm to 5 µm, and a width ranging from 50 nm to 50 µm.

7. The printing screen of claim 2, wherein the grid lines of the screen body are defined to extend along a Y direction, and an X direction crossing the Y direction is defined as a printing direction; along the X direction, the microstructure is provided with an adjustment portion for adjusting resistance of a squeegee during printing.

8. The printing screen of claim 7, wherein in a Z direction perpendicular to a plane formed by the X direction and the Y direction, the adjustment portion has a depth ranging from 3 µm to 25 µm when recessed, and a thickness ranging from 3 µm to 25 µm when protruding.

9. The printing screen of claim 7, wherein the adjustment portion is a tip portion directed opposite to the X direction.

10. The printing screen of claim 7, wherein the adjustment portion is linear and arranged at an included angle relative to the X direction.

11. The printing screen of claim 2, wherein the microstructure is a mesh texture comprising intersecting first mesh lines and second mesh lines, wherein the first mesh lines and/or the second mesh lines are arranged at an included angle relative to the X direction.

12. The printing screen of claim 11, wherein the included angle ranges from 5° to 85°.

13. The printing screen of claim 1, wherein the surface treatment layer comprises a microstructure provided on the bottom surface, and the microstructure comprises an AG texture.

14. The printing screen of claim 1, wherein the surface treatment layer comprises a coating structure provided on the bottom surface, and the coating structure is a fluorine-containing layer, a softening layer or a plating layer.

15. The printing screen of claim 1, wherein the screen body comprises a first metal layer and a second metal layer that are stacked; the grid lines of the screen body comprise first wire grooves located in the first metal layer and second wire grooves located in the second metal layer, wherein the first wire grooves and the second wire grooves overlap and communicate with each other; the printing surface is provided on the first metal layer, and the bottom surface is provided on the second metal layer; side walls of the first wire grooves and/or the second wire grooves are provided with fluorine-containing layers or plating layers.
